Europäisches Patentamt

European Patent Office

Office européen des brevets

(19)

(11) **EP 0 609 707 B1**

(12) **EUROPÄISCHE PATENTSCHRIFT**

(45) Veröffentlichungstag und Bekanntmachung des Hinweises auf die Patenterteilung:
**17.03.1999 Patentblatt 1999/11**

(51) Int Cl.[6]: **G01R 23/167**

(21) Anmeldenummer: **94100752.8**

(22) Anmeldetag: **20.01.1994**

(54) **Verfahren zur Momentanfrequenz-Detektion**

Process for detecting the instantaneous frequency

Procédé pour la détermination de la fréquence momentanée

(84) Benannte Vertragsstaaten:
**DE ES FR GB NL**

(30) Priorität: **01.02.1993 DE 4302679**

(43) Veröffentlichungstag der Anmeldung:
**10.08.1994 Patentblatt 1994/32**

(73) Patentinhaber: **Daimler-Benz Aerospace Aktiengesellschaft**
**81663 München (DE)**

(72) Erfinder: **Zimmer, Manfred, Dr.**
**D-89077 Ulm (DE)**

(74) Vertreter: **Fröhling, Werner Otto, Dr. et al**
**Daimler-Benz Aerospace AG**
**Patentabteilung**
**Sedanstrasse 10**
**89077 Ulm (DE)**

(56) Entgegenhaltungen:
**EP-A- 0 335 284      US-A- 4 326 261**

- **SIGNAL PROCESSING VI, THEORIES AND APPLICATIONS,PROCEEDINGS OF EUSIPCO-92, Bd.II, 24. August 1992, BRUSSELS,BE Seiten 851 - 854, XP000348519 CIZEK 'INSTANTANEOUS FREQUENCY AND ITS MEASUREMENTS USING DIGITAL FILTERS'**
- **APPLIED OPTICS, Bd.31, Nr.8, 10. März 1992, NEW-YORK,US Seiten 1015 - 1029, XP000258283 KNIFFEN 'BISPECTRAL MAGNITUDE AND PHASE RECOVERY USING A WIDE BANDWIDTH ACOUSTO-OPTIC PROCESSOR'**

**Beschreibung**

Die Erfindung betrifft ein Verfahren zur Momentanfrequenz-Detektion nach dem Oberbegriff des Patentanspruchs 1. Insbesondere in der Radar- und/oder Kommunikationstechnik, vor allem bei der Demodulation von sogenannten Frequency Shift Keying (FSK)- und/oder sogenannten Phase Shift Keying (PSK)-Signalen, ist es erforderlich, die Momentanfrequenz eines analogen elektrischen Signals zu bestimmen.

Ein Verfahren besteht darin, mit Hilfe einer sogenannten Torschaltung (Start-Stop-Schaltung) die gesuchte Momentanfrequenz zu bestimmen. Dabei wird bei dem analogen (Wechselspannungs-)Signal z.B. zwischen zwei Nulldurchgängen, z.B. jeweils zwischen den ansteigenden Flanken, die Zeit gemessen und daraus die Momentanfrequenz bestimmt.

Diese Zeiterfassung erfolgt im allgemeinen in digitaler Form mit Hilfe eines Taktsignales, dessen bekannte Pulswiederholfrequenz wesentlich höher ist als die höchste Periodendauer des zu messenden Signals. Es wird dann lediglich die Anzahl der Takte zwischen den erwähnten Nulldurchgängen des Signals gezählt. Aus dieser Anzahl und der bekannten Pulswiederholfrequenz kann die gesuchte Frequenz bestimmt werden. Diese Anzahl kann aber auch als ein digitales Frequenzwort betrachtet werden, welches der gesuchten Frequenz zugeordnet ist. Ein solches Frequenzwort kann z.B. in einer nachgeschalteten Datenverarbeitungsanlage in digitaler Form ausgewertet werden.

Ein erster Nachteil eines solchen Verfahrens besteht darin, daß die Pulswiederholfrequenz aufgrund des Abtasttheorems immer wesentlich größer als die zu messende Frequenz sein muß. Die höchstmögliche Pulswiederholfrequenz ist aber begrenzt, insbesondere durch die Elektronenlaufzeiten in den verwendeten elektronischen Bauelementen und/oder Baugruppen.

Ein zweiter Nachteil besteht darin, daß Quantisierungsfehler entstehen, die insbesondere bei hohen (Signal-) Frequenzen störend sind. Diese Quantisierungsfehler beruhen z.B. darauf, daß das zu bestimmende Signal und das Taktsignal im allgemeinen unkorreliert sind. Zu diesem systematischen Quantisierungsfehler kommen dann insbesondere bei hohen Frequenzen noch weitere unsystematische Fehler, die z.B. auf Rausch- und/oder Jittereffekten realer Schaltungsanordnungen beruhen.

Aus dem Dokument: Instantaneous frequency and its measurement using digital filters; CIZEK, Vaclav V.; in: Signal Processing VI: Theories and Applications; Herausgeber: Vandewalle J., Boite R. und Oosterlinck A.; 1992, Elsevier Science Publishers B.V.; Seiten 851-854, ist es bekannt, daß für die Ermittlung einer momentanen Frequenz eines analytischen Signals als Hilfssignale die Hilbert-Transformation des analytischen Signals, dessen Ableitung und die Ableitung der Hilbert-Transformation erforderlich sind. Diese Hilfssignale können lediglich mit begrenzter Genauigkeit ermittelt werden. In dem Dokument werden daher die Einflüsse dieser ungenau ermittelten Hifssignale auf die Bestimmung der Genauigkeit der momentanen Frequenz beschrieben.

Der Erfindung liegt die Aufgabe zugrunde, ein gattungsgemäßes Verfahren anzugeben, mit dem in zuverlässiger und kostengünstiger Weise auch bei hohen Frequenzen sowie während einer möglichst kurzen Meßdauer eine Frequenzbestimmung möglich wird.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein erster Vorteil der Erfindung besteht darin, daß bei dem zu messenden Signal zunächst eine Phasenquantisierung vorgenommen wird und die dabei erzeugten digitalen Phasenworte anschließend mit Hilfe einer digitalen Mittelwertbildung ausgewertet werden. Dadurch wird eine hohe Meßgenauigkeit erreicht.

Ein zweiter Vorteil besteht darin, daß eine Signalverarbeitung in einer parallen Grund-Schaltungsstruktur möglich wird. Dadurch ist eine extrem schnelle Signalverarbeitung möglich, z.B. können mit derzeit erhältlichen Halbleiterschaltungen analoge Signale mit einer Frequenz größer 100 MHz und einer Meßdauer kleiner 100 ns zuverlässig detektiert werden.

Ein dritter Vorteil besteht darin, daß für die Mittelwertbildung keine Koeffizienten-Multiplizierer benötigt werden.

Ein vierter Vorteil besteht darin, daß eine Verringerung der Abtastwerte möglich wird ohne daß eine Verringerung der Frequenzauflösung und/oder Meßgenauigkeit erfolgt. Dadurch sind auch höchste Frequenzen mit relativ langsamen Halbleiterbauelementen meßbar.

Ein fünfter Vorteil besteht darin, daß eine Mittelwertbildung mit einer Kaskadierung von Teilfiltern möglich wird, wodurch eine exponentielle Steigerung der stochastischen Meßgenauigkeit bei gleichzeitiger Reduzierung der Speicherzellen - und/oder Addierstufenanzahl erreicht wird.

Weitere Vorteile sind der nachfolgenden Beschreibung entnehmbar.

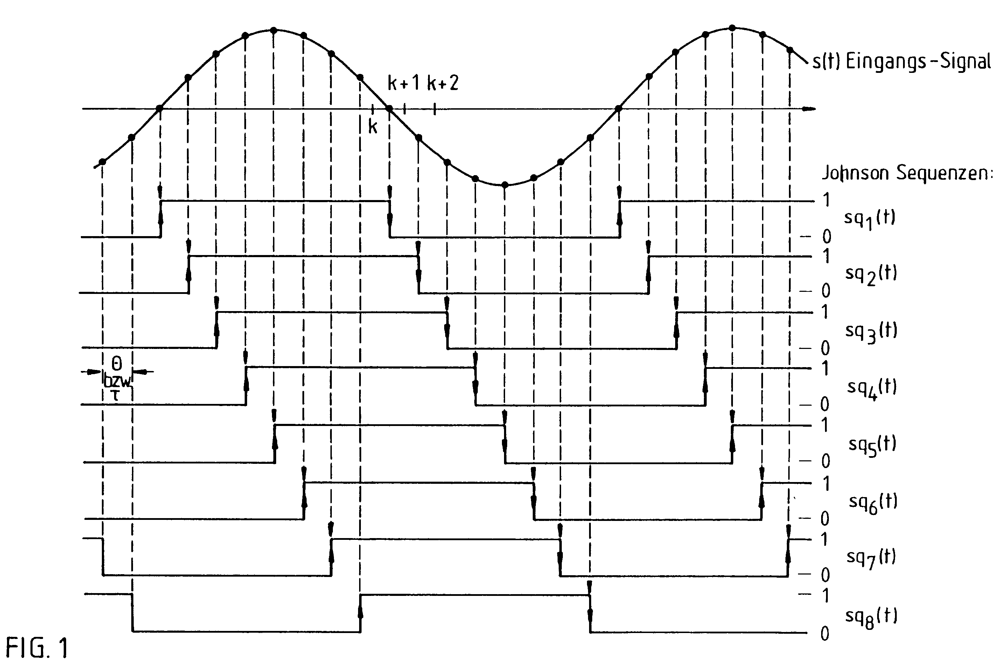

Die Erfindung wird im folgenden anhand von Ausführungsbeispielen und unter Bezug auf schematisch dargestellte Zeichnungen näher erläutert. Es zeigen FIG. 1 bis FIG. 7 schematisch dargestellte Diagramme zur Erläuterung der Erfindung.

Die Erfindung beruht auf der direkten digitalen Detektion (DDD) von Momentanfrequenzen, was nachfolgend näher erläutert wird.

Das Ziel einer digitalen Momentanfrequenz-Detektion ist es, bei möglichst kurzer Meßdauer $\tau$ (typisch < 100 ns) eine unbekannte Frequenz $f_x$ eines von der Zeit t abhängigen sinusförmigen Signals

$$s(t) = A_x \cdot \sin(2\pi f_x \cdot t + \varphi_x) \text{ mit } 0 \leq \varphi_x \leq 2\pi$$

$$\text{bzw.} \tag{1}$$

$$s(t) = A_x \cdot \sin(\varphi(t)) \qquad \text{mit } 0 \leq \varphi(t) \leq 2\pi,$$

mit entsprechender Genauigkeit bzw. Auflösung q zu bestimmen. D.h. die analoge Signalfrequenz $f_x$ wird durch diskrete Frequenzwerte $F_x$ aus einem endlichen Wertevorrat $Q_F$ dargestellt. Dabei gehört zu der Frequenz $f_x$ des sinusförmigen Signals s(t) eine Periodendauer $T_x$ gemäß der Formel

$$f_x = \frac{1}{T_x} \tag{2}$$

Alternativ dazu kann die Momentanfrequenz $f_x = f(t)$ von dem in Gl. 1 (Gleichung 1) genannten Phasengang $\varphi(t)$ des Meßsignales s(t) abgeleitet werden.

Mathematisch stellt die Momentanfrequenz f(t) eines Signals die zeitliche Ableitung seines Phasenwinkelverlaufs $\varphi(t)$, also die Winkelgeschwindigkeit $\omega$, dar. Damit kann als Detektionsprinzip die Bildung des Differentialquotienten im Tiefpaßbereich

$$f_T(t) = \frac{1}{2\pi} \cdot \frac{d\varphi_T(t)}{dt} \text{ mit } \varphi_T(t) = \varphi_O + 2\pi \int_{-\infty}^{\infty} f_T(t)\,dt \tag{3}$$

oder im Bandpaßbereich

$$f(t) = f_O + \frac{1}{2\pi} \cdot \frac{d\varphi_T(t)}{dt} \text{ mit } \varphi(t) = 2\pi f_O + \varphi_O + 2\pi \int_{-\infty}^{\infty} f_T(t)\,dt \tag{4}$$

aus dem Phasengang $\varphi_T(t)$ des Tiefpaßsignals $s_T(t)$ aufgefaßt werden. Jedoch ist für die Frequenzmessung im Bandpaßbereich im Meßergebnis für f(t) noch eine Frequenz-Offset-Konstante $f_o$ hinzuzuaddieren, die die Mittenfrequenz des Meß-Bandpasses $B_M$ darstellt.

Nun kann diese Meßvorschrift, Gl. 3 und Gl. 4, besonders vorteilhaft bei der direkten digitalen Detektion (DDD) angewandt werden. Dieses Verfahren erfordert zunächst eine Phasenquantisierung des Eingangssignales s(t) durch einen Phasen/Digital-Umsetzer (PDU), der z.B. aus der deutschen Offenlegungsschrift DE-OS 38 33 005 bekannt ist. Dabei werden zu dem Eingangssignal s(t) gehörende digitale Phasenworte $\phi(k)$ erzeugt, wobei k eine ganze Zahl ist und nachfolgend noch näher erläutert wird und wobei eine Kodierung nach dem Johnson-Code erfolgt.

FIG. 1 zeigt beispielsweise ein von der Zeit t abhängiges Eingangssignal s(t), das zunächst mit Hilfe von beispielsweise acht ($1 \leq i \leq 8$) parallel geschalteten Phasenstellgliedern, die jeweils eine Phasenverschiebung i·$\theta$ (entspricht i·$\tau$, wobei $\tau$ die $\theta$ entsprechende Zeitverschiebung ist) bewirken, in sogenannte 8-bit-Johnson-Sequenzen $sq_i$(t), $1 \leq i \leq 8$, umgewandelt wird. Erfolgt nun eine digitale Abtastung dieser 8-bit-Johnson-Sequenzen $sq_i$(t), z.B. jeweils in der Mitte der durch die gestrichelten Linien dargestellten Zeitintervalle, mit einem Takt T, dessen Pulse gezählt werden ($1 \leq k \leq \infty$), so entstehen nach der Abtastung Phasenworte $\phi(k)$ im 8bit-Johnson-Code. In FIG. 1 gehört beispielsweise zu der Phasenlage bei den Takten k, k+1, k+2 die Phasenworte $\phi(k)=11111111$, $\phi(k+1)=01111111$, $\phi(k+2)=0011111$. Diese im Johnson-Code vorliegenden Phasenworte können dann in einen für die weitere Signalverarbeitung geeigneten Code, z.B. einen Binär-Code umgewandelt werden. Besonders vorteilhaft ist eine Umwandlung in den an sich bekannten 2er-Komplement-Code, was noch erläutert wird.

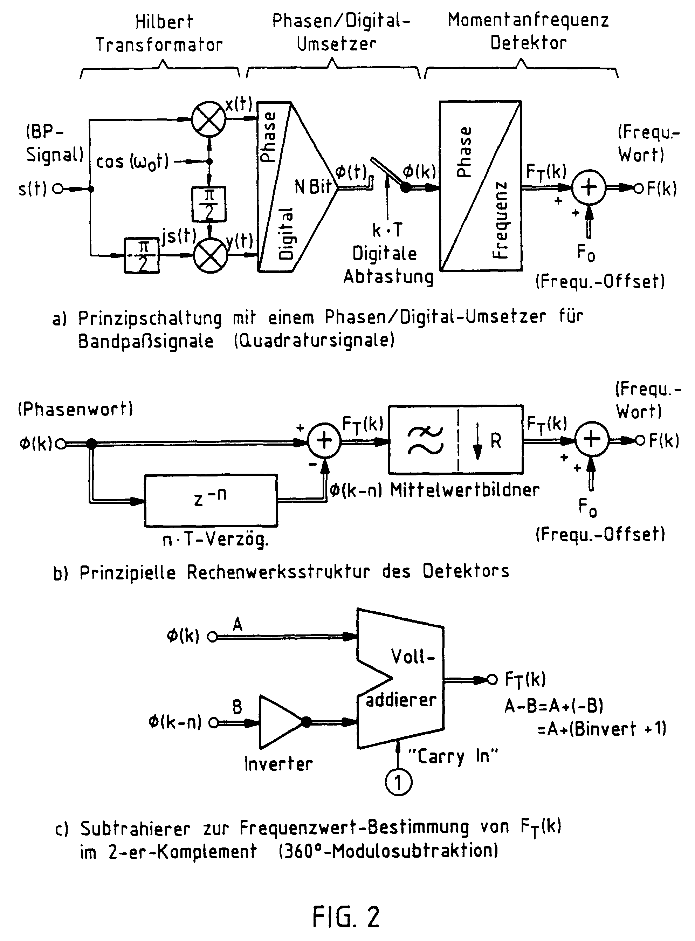

FIG. 2a zeigt in einem schematischen Blockbild eine Prinzipschaltung mit einem vorstehend beschriebenem Phasen/Digital-Umsetzer (PDU) für ein analoges Eingangssignal s(t), das als Bandpaßsignal vorliegt und das zunächst mit einem an sich bekannten Hilbert-Transformator in Quadratursignale x(t), y(t) umgewandelt wird. Nach der digitalen Abtastung werden die Phasenworte $\phi(k)$ mit Hilfe eines Phasen-Frequenzwortwandlers, der noch beschrieben wird, in Frequenzworte $F_T(k)$, welche den Frequenzen des Bandpaßsignales entsprechen, umgewandelt. Zu diesen Frequenzworten $F_T(k)$ wird dann noch in digitaler Form ein Frequenzwort $F_o$ (Frequenz-Offset) addiert, welches die Frequenzlage (z.B. die Mittenfrequenz) des Bandpaßsignales enthält. Nach dieser Addition entstehen dann Frequenzworte $F(k)$, welche absolute Frequenzangaben beinhalten. Liegt das Eingangssignal s(t) als Tiefpaßsignal vor, so wird die Addition des Frequenzwortes $F_O$ nicht benötigt.

Zur Momentanfrequenz-Bestimmung nach dem DDD-Verfahren ist die digitale Ausführung des Differential-quotienten des Phasenverlaufs $\varphi(t)$nach Gl. 3 oder 4 nötig. Dies geschieht anhand des vom PDU gelieferten, digitalen Phasenwinkels $\phi(k)$ (Phasenworte). Damit kann der Differentialquotient für f(t) durch den digitalen Differenzquotienten

$$f(k) = \frac{1}{2\pi} \cdot \frac{\phi(k)-\phi(k-n)}{T(k)-T(k-n)} = \frac{1}{2\pi} \cdot \frac{\Delta\phi_k}{\Delta T} \tag{5}$$

angenähert werden. Diese direkte digitale Detektion nach FIG. 2 hat in Abhängigkeit der Phasenwinkelauflösung $\theta$ des PDU's, der Abtastperiodendauer T bzw. der zeitlichen Differenz $\Delta T$ der Phasenworte $\phi(k)$ sowie der verwendeten Rechenwerksparameter einen zugehörigen linearen Frequenzfehler $\Delta f$ bzw. eine endlich genaue Frequenzauflösung q (Rechenwerksauflösung).

Deshalb ist für die technische Anwendung das DDD-Grundprinzip nach Gl. 5 wegen seiner zu geringen Rechenwerksauflösung

$$q = \frac{1}{2\pi} \cdot \frac{\theta}{T} = 2^{-N} \cdot f_A \qquad \text{mit } f_A = \frac{1}{T} \tag{6}$$

meist so nicht anwendbar. Daher wird durch eine nachfolgende, digitale Integration bzw. Mittelung die Frequenzauflösung q und weitere Parameter, wie z.B. der Signalstörabstand $D_f$ der Detektion, erheblich verbessert. Hierfür wird nach FIG. 2b ein spezieller Mittelwertbildner mit einer Abtastraten-Reduktion vom Faktor R und im Falle einer Bearbeitung von Bandpaßsignalen ein Frequenzoffset-Addierer dem eigentlichen DDD-Detektor nachgeschaltet. Diese vorteilhaften Detektionsfilter für den Mittelwertbildner werden noch näher beschrieben.

Hier soll nun zunächst auf eine technische Besonderheit bei der digitalen Differenzquotienten-Bildung aus den Phasenwinkeln $\phi(k)$ nach Gl. 5 eingegangen werden. Es ist der "Modulo-Charakter" dieser Differenzquotienten zu beachten. Die Division, Gl. 5, ist also eine Zeitdivision eines digitalen Differenzwertes. Hierbei stellt der Divisor die äquivalente Abtastperiodendauer $\Delta T$ des vorliegenden Abtastsystems dar. Daraus folgt, daß nur digitale Differenzen aus entsprechend verzögerten Phasenworten $\phi(k)$ in einem digitalen Rechenwerk zu bilden sind. D.h. an den Subtrahiererausgängen des digitalen Rechenwerks, FIG. 2b, dürfen keine Phasendifferenzen > I180°I auftreten. Damit ist also eine Modulo-Subtraktion bezüglich 360° ($2\pi$) auszuführen. Außerdem bedeutet dies, daß das Abtasttheorem - mindestens 2 Abtastwerte pro Phasenwinkelperiode - dadurch erfüllt ist. Folglich lautet jetzt die Gl. 5 vollständig:

$$F_T(k) = \frac{1}{2\pi} \left[ \frac{\Delta\phi_k}{\Delta T} \right] \bmod 2\pi \tag{7}$$

Die Abkürzung "mod" stellt hierbei den Modulooperator dar, wobei allgemein für die Modulooperation bezüglich $2\pi$ gilt:

$$\varphi \bmod 2\pi = \varphi - 2\varphi \left[ \text{int} \frac{\varphi}{2\pi} \right] \tag{8}$$

und somit den Restwinkel innerhalb des $2\pi$-Bereichs bei vorliegendem, ganzzahligen Vielfachen von $2\pi$ ergibt.

Nun ist der erwähnte 2er-Komplement-Code wegen seiner zyklischen Eigenschaften besonders vorteilhaft zur Darstellung der mit $2\pi$-periodischen Phase der Modulo-Subtraktion geeignet. Unter Anwendung des 2er-Komplements in der Form nach FIG. 2c lassen sich sowohl Frequenzen als auch Phasendifferenzen bei Vorzeichenwechsel aufeinanderfolgender Phasenwerte (z.B. Übergang von Quadrant II nach Quadrant III) einfach ermitteln. Nach den Rechenregeln des 2er-Komplements wird die Differenz A-B dadurch gebildet, daß man sämtliche Bits vom Wort B invertiert und das so gebildete Wort zum Wort A addiert sowie der Summe außerdem noch den Wert +1(Carry) hinzufügt. Damit sind beim DDD-Verfahren keinerlei Korrekturen nötig um irgendwelche unerwünschten Phasenfehler bei Abarbeiten des Rechenwerksalgorithmusses, Gl. 7, zu kompensieren. Dies ist unter anderem auch ein besonderes Merkmal des DDD-Verfahrens.

Die direkte digitale Detektion (DDD) von Momentanfrequenzen, FIG. 2b, erfordert in den meisten Fällen noch eine digitale Nachverarbeitung des Meßwertes $F_T(k)$ mit speziellen Mittelungsfiltern. Der Differenzquotient, Gl. 5, des DDD-Verfahrens liefert vergleichsweise nur eine geringe Frequenzauflösung q, Gl. 6, die bei weitem nicht ausreicht, die in der technischen Realität auftretenden Fluktuationen (Quantisierungsfehler, Rauschen, Jitter und Modulationseffekte) der einzelnen Phasenworte $\phi(k)$ zu kompensieren.

Wird zur technischen Realisierung das Prinzip von ungewichteten Mittelwertbildungen, d.h. von linearen Mittelungen mit den Wichtungsfaktoren +1, 0 und -1 angewandt, so ergeben sich besonders einfache Rechenwerksstrukturen. Natürlich müssen diese Strukturen und dazugehörigen Rechenwerksparametern, wie z.B. die Blocklänge M (Anzahl der zur Mittelung herangezogenen Phasenworte $\phi(k)$) in Abhängigkeit der Abtastfrequenz $f_A$ bzw. Abtastperiode T, der Phasenauflösung $\theta$ für die erforderlichen Frequenzauflösungen $q_o$ und $q_f$ sowie für die Detektionsfehler $\Delta f$ und $\sigma_f$ entsprechend optimiert werden. Auch die Rechenzeit (Meßzeit) $T_M$ und Laufzeit $\tau_M$ der Filter auf Frequenzänderung (Modulationen) des Meßsignals s(t) einschließlich ihrer 3-dB-Filterbandbreiten $f_g$ ist in Rechnung zu stellen.

Zur Filter-Dimensionierung werden unter anderem noch folgende Parameter herangezogen:

a) die Rechenwerks-Frequenzauflösung $q_o$ - kurz nur als Rechenwerksauflösung bezeichnet -, die den kleinsten noch darstellbaren Frequenzwert infolge des endlichen Ganzzahlwertebereichs des Rechenwerks angibt;

b) den Effektivwert $\sigma_f$ (Standardabweichung) des absoluten Frequenzmeßfehlers $\Delta f$. Daraus kann dann in der Regel die effektive Frequenzauflösung $q_f$ des Detektionsfilters berechnet werden;

c) der Signalstörabstand $D_f$, der sich am Ausgang des Filters bei idealem, rauschfreien Eingangsphasensignal einstellt;

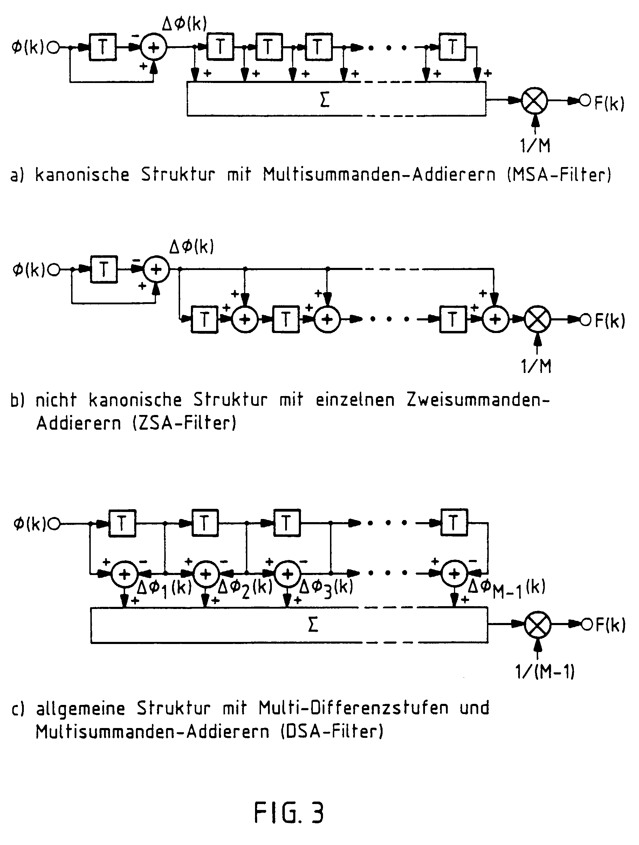

e) die effektive Bitzahl $N_f$. Sie ist eine fiktive Bitzahl einer angenommenen Phasenquantisierung, die bei der Einfachmittelung nach FIG. 3a und 3b und gleicher Filterlänge M, die gleiche effektive Frequenzauflösung qf ergibt, die dem zugrundeliegenden Filter mit der tatsächlichen Quantisierungsbitzahl N entspricht.

Somit gilt für diese Detektionsfilter unter Verwendung der effektiven Bitzahl $N_f$ allgemein für ihre effektive Frequenzauflösung:

$$q_f = \frac{1}{M} \cdot f_A \cdot 2^{-N_f} \tag{9}$$

Dagegen kann nur im Fall von nicht kaskadierten Filtern und damit ohne Abtastratenreduktion die 3-dB-Filterbandbreite mit

$$f_g = \frac{M}{M(2M+1)-2} \cdot f_A \qquad \text{für } M \geq 2 \text{ bzw.} \tag{10}$$

$$f_g \approx \frac{1}{(2M+1)} \cdot f_A \qquad \text{für } M >> 2$$

angegeben werden. Zwischen der Filterbandbreite $f_g$ und der effektiven Frequenzauflösung $q_f$ besteht ein nicht ganz linearer Zusammenhang, der noch später aufgezeigt wird. Mit Hilfe dieser Parameter ist es nun leicht möglich, die Detektionsfilter grundsätzlich zu klassifizieren. Dies wird in den folgenden Abschnitten kurz ausgeführt.

Die drei Filterversionen nach FIG. 3 stellen die einfachsten, technisch möglichen Ausführungsformen dar. Hierbei sind die beiden ersten Versionen, MSA- und ZSA-Filter, FIG. 3a und 3b, in der Anwendung vollständig gleichwertig. Beide Realisierungen haben dieselbe Übertragungsfunktion, die eine geht aus der anderen durch Transponieren hervor. Dem Modulosubtrahierer, der den eigentlichen Differenzquotienten $\Delta\phi(k)$, Gl. 7, bildet, ist zur Mittelung der Frequenzworte

$$F(k) = \frac{1}{2\pi M} \cdot \sum_{i=0}^{M-1} \Delta\phi(k-i) \qquad \text{mit} \qquad (11)$$

$$\Delta\phi(k) = [\phi(k) - \phi(k-1)] \bmod 2\pi$$

jeweils ein Transversalfilter mit den insgesamt gleichen Koeffizienten von dem Wert = 1 (deshalb in FIG. 3 nicht eingezeichnet) nachgeschaltet. Hierbei ergibt sich eine Rechenwerksauflösung

$$q_o = q_f = \frac{1}{M} \cdot f_A \cdot 2^{-N} , \qquad (12)$$

die mit der effektiven Frequenzauflösung $q_f$ identisch ist. Gegenüber der direkten Methode, Gl. 6, wird der Wert für die Frequenzauflösung $q_o$ und $q_f$ um den Faktor M verbessert, bzw. der effektive Frequenzfehler (Standardabweichung)

$$\sigma_f = \frac{1}{2\pi} \cdot \frac{\theta}{\sqrt{12}} \cdot \frac{1}{\sqrt{M}} \qquad \text{mit } \theta = 2\pi \cdot 2^{-N} \qquad (13)$$

um den Wert $1/\sqrt{M}$ verringert. Damit kann für den Signalstörabstand dieses Frequenzdetektors die Formel

$$D_f \approx 6,02(N-1) + 10 \log M \qquad \text{in dB} \qquad (14)$$

angegeben werden. Für die Filterlaufzeit $\tau_M$, die die Hälfte der Meßzeit $T_M$ beträgt, ist dann zu setzen

$$\tau_M = \frac{T_M}{2} = \frac{(M-1)}{2} \cdot T \qquad (15)$$

Jedoch für die Filterbandbreite fg gilt weiterhin die Gl. 10.
Eine weitere Variante dieses Einzelwert-Integrationsverfahrens ist nun nach FIG. 3c möglich, bei der M-1 Differenzquotienten $\Delta\phi_i(k)$ aus entsprechend verzögerten $\phi(k)$-Worten gebildet werden, die dann anschließend nur aufzusummieren sind.
Die Frequenzworte des DAS-Filters

$$F(k) = \frac{1}{2\pi(M-1)} \sum_{i=0}^{M-2} [\phi(k-i)-\phi(k-i-1)] \bmod 2\pi \qquad (16)$$

sind formal mit dem Ausdruck

$$F^*(k) = \frac{1}{2\pi(M-1)} [\phi^*(k) - \phi^*(k-M-1)] \bmod 2\pi \qquad (17)$$

identisch, jedoch geht hierbei der Mittelungseffekt der Mehrsummanden-Summation für die stochastischen Phasenwinkelabweichungen (Phasenrauschen usw.) verloren. Deshalb darf zur Bestimmung der statistischen Parameter nur die Gl. 16 herangezogen werden. Damit besitzt hier die Rechenwerksauflösung

$$q_o = \frac{q_f}{2} = \frac{1}{(M-1)} \cdot f_A \cdot 2^{-N} \qquad (18)$$

einen halb so großen Wert wie die effektive Frequenzauflösung $q_f$. Dies zeigt sich auch im Effektivwert des Frequenzfehlers

$$\sigma_f = \frac{1}{2\pi} \cdot \frac{\theta}{\sqrt{6}} \cdot \frac{1}{\sqrt{M-1}} \qquad (19)$$

und des Signalstörabstandes

$$D_f \approx 3{,}01(2N\text{-}3) + 10 \log (M\text{-}1) \qquad \text{in dB} \qquad (20)$$

Eine erhebliche Verbesserung der stochastischen Parameter, so vor allem beim effektiven Frequenzfehler $\sigma_f$, bei der effektiven Frequenzauflösung $q_f$ und dem Signalstörabstand $D_f$, erbringen die im nachfolgenden Abschnitt beschriebenen Verfahren, sogenannte Multiblock-Integrationsverfahren.

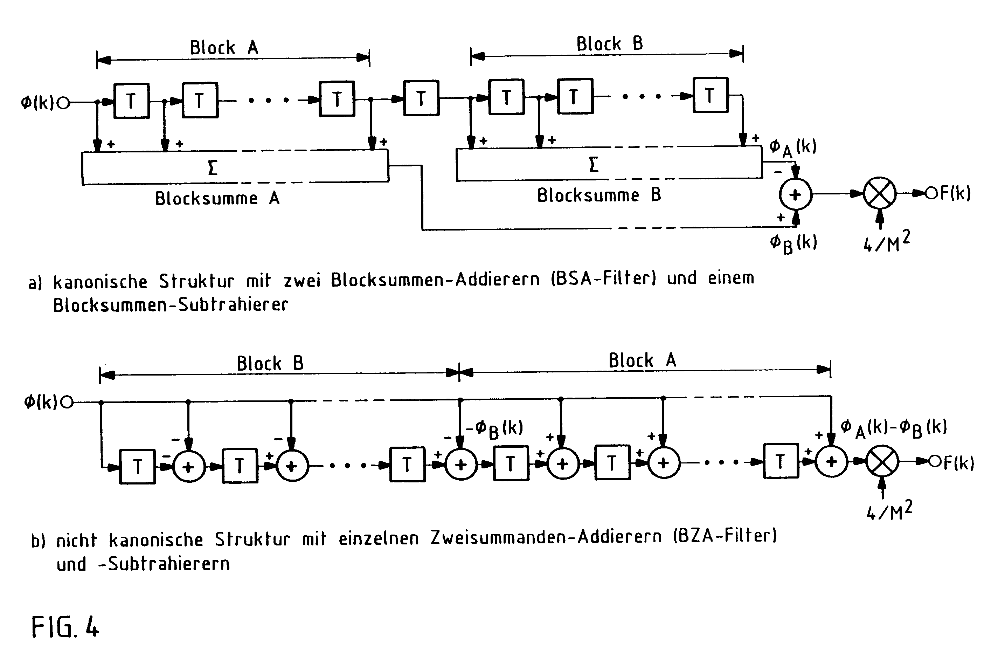

Grundlage des Multiblock-Integrationsverfahrens ist das sogenannte Doppelblock-Integrationsverfahren oder auch "Bicentroid-Verfahren". Gleichzeitig bei geringem technischen Aufwand erbringt es nach FIG. 4 eine besonders gute Unterdrückung von Rauscheffekten. Es erreicht für nicht zu große Phasenwinkelwortfolgen $\phi(k)$ der Länge M (M < 200) fast den gleichen sogenannten "Processing Gain" des bekannten Verfahrens nach dem Prinzip des kleinsten Fehlerquadrates nach Gauß. Jedoch ist hierbei der Rechenaufwand im Verhältnis zum Verfahren nach Gauß vorteilhafterweise wesentlich kleiner.

Ebenfalls sind hier wie bei Einzelwert-Integrationsverfahren, Gl. 11, zwei technische Ausführungsformen möglich, die identische Übertragungseigenschaften besitzen. Das Filter mit der kanonischen Struktur, FIG. 4a, wird deshalb als BSA-Filter und das nicht kanonische Doppelblockfilter, FIG. 4b, als BZA-Filter bezeichnet. Bei beiden Detektoren werden blockweise getrennt zwei gleich lange Wortfolgen der Länge M/2, Block A und Block B, von Phasenwinkeln aufsummiert und dann anschließend die beiden Blocksummen A und B (Phasenworte $\phi_A(k)$ und $\phi_B(k)$) voneinander subtrahiert.

Die Modulosubtraktion erfolgt hier entsprechend dem Wert M·π. Damit besitzt dieses Verfahren einen quadratischen Glättungseffekt zur Gewinnung der Frequenzwerte

$$F(k) = \frac{4}{2\pi M^2} \sum_{i=0}^{M-1} [\phi(k\text{-}i) - \phi(k\text{-}M\text{-}i)] \bmod M\text{·}\pi \qquad (21)$$

bei einer Rechenwerksauflösung $q_o$, die mit Gl. 12 der einfachen Einzelwert-Mittelung identisch ist. Die besondere Wirksamkeit des Verfahrens dokumentiert sich aber in der effektiven Frequenzauflösung

$$q_f = \frac{4}{M^2} \cdot f_A \cdot 2^{-N} \qquad (22)$$

sowie beim Effektivwert des Frequenzfehlers

$$\sigma_f = \frac{1}{2\pi} \cdot \frac{\theta}{\sqrt{12}} \cdot \frac{4}{M\sqrt{M}} \qquad (23)$$

und dementsprechend auch bei seinem Signalstörabstand

$$D_f \approx 6{,}02(N\text{-}3) + 30 \log M \qquad \text{in dB} \qquad (24)$$

Mit den folgenden Beispielen, bei denen eine Kaskadierung der bisher beschriebenen Filter für die Mittelwertbildung erfolgt, ergeben sich weitere vorteilhafte Verbesserungen der Parameter bei gleichzeitiger drastischer Verringerung des Schaltungsaufwandes, insbesondere der Verringerung der Anzahl der benötigten Speicherzellen.

Die Abtastfrequenz muß immer in Einklang mit dem augenblicklichen Frequenz inhalt - Abtasttheorem - des Filters stehen. Wird durch ein (digitales) Tiefpaßfilter der Frequenzinhalt gesenkt, so kann dementsprechend auch die Abtastfrequenz hinter dem Filter reduziert werden. Nichtrekursive Filter eignen sich besonders gut für diese Aufgabe, weil sie in sehr einfacher Weise gestatten, die Ausgangtaktfrequenz zu senken: Man berechnet die nicht benötigten Zwischenergebnisse einfach nicht. Daraus ergibt sich zu dem ein erheblicher Vorteil bezüglich Aufwand und Geschwindigkeit. So sind nur die Resultate des vorangegangenen Teilfilters bei entsprechender reduzierter Abtastrate von dem nachfolgenden Filter weiterzuverarbeiten.

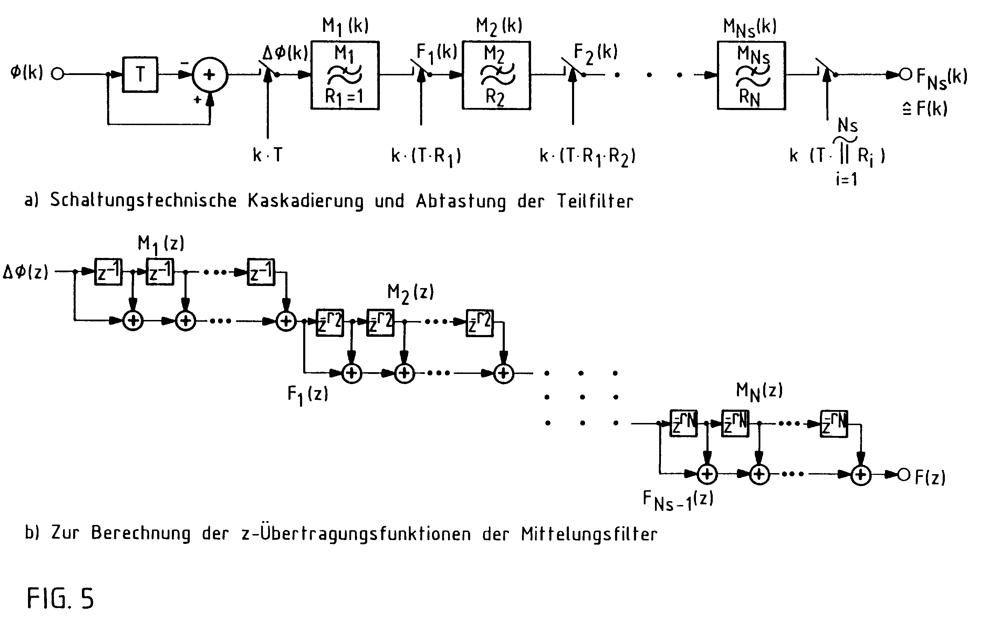

Hier wird nun auf besondere Weise von der Abtastratenreduktion mit den Faktoren $R_i$ bzw. $r_i$ bei der Hintereinanderschaltung (Kaskadierung) von mehreren Detektionsfiltern Gebrauch gemacht. Die in FIG. 5a gezeigte Kaskadierungsstruktur eines $N_s$-stufigen Mittelungsfilters mit seinen einzelnen Filterstufen der Länge $M_i$ und deren diskreten Stoßfunktionen $M_i(k)$ ermöglicht eine besonders vorteilhafte Abtastratenstaffelung, wenn für die jeweiligen Abtastraten-Reduktionsfaktoren gesetzt wird:

$$R_1 = 1, \quad R_{i+1} = M_i \quad \text{und} \tag{25}$$

$$R_{\text{gesamt}} = \prod_{i=1}^{N_s} R_i \quad \text{mit } i=1,2,3,\ldots,N_s-1.$$

D.h. die Abtastfrequenz $f_r$ am Ausgang des jeweiligen Filterabschnittes wird genau um den Faktor $M_i$ des betroffenen Filterabschnittes abgesenkt und damit die nachfolgende Filterstufe getaktet. Dies zeigt sich besonders deutlich anhand der z-transformierten Übertragungsfunktion $M(z)$ des Gesamtfilters, FIG. 5b. Der Verzögerungsfaktor $r_i$ - ist hier die negative Potenz der jeweiligen z-Variabeln - erhält man über die entsprechende Taktperiodendauer $T_i$ = $1/f_r$ des entsprechenden Filterabschnittes nach folgender Beziehung:

$$r_{i+1} = \frac{M_i \cdot T_i}{T} = \frac{1}{T} \prod_{n=1}^{i} T_n \quad . \tag{26}$$

Ebenfalls gilt hier $r_1 = 1$. Außerdem ist damit das Abtasttheorem immer genau erfüllt, denn die reduzierten Filterbandbreiten, Gl. 10, der einzelnen Filterstufen sind immer etwas kleiner als die Hälfte der Stufenabtastfrequenz $f_r$. Der besondere Vorteil dieses Verfahrens zeigt sich vor allem bei den stochastischen Filterparametern. So ergibt sich für die (deterministische) Rechenwerksauflösung nur ein Wert von

$$q_o = \frac{1}{L} \cdot f_A \cdot 2^{-N} \quad \text{mit}$$

$$L = \prod_{i=1}^{N_s} M_i \quad \text{für } i=1,2,3,\ldots,N_s \tag{27}$$

wobei L der Mittelungsproduktfaktor darstellt und mit der Gesamtfilterlänge identisch ist. Jedoch ist schon beim Effektivwert des Frequenz fehlers

$$\sigma_f = \frac{2^{(1-N)}}{\sqrt{12}} \cdot \frac{\sqrt{S}}{L} \qquad \text{mit}$$

$$\qquad (28)$$

$$S = \sum_{i=1}^{N_S} M_i$$

unter Verwendung des Mittelungssummenfaktors S eine wesentliche Verbesserung gegenüber den herkömmlichen Methoden, Gl. 12 usw., gegeben. Gleichermaßen gilt dies auch für den Signalstörabstand.

$$D_f \approx 6{,}02(N-1) + 10 \log \left(\frac{L^2}{S}\right) \qquad \text{in dB} \qquad (29)$$

sowie für die effektive Bitzahl

$$N_f \approx 1 + \frac{D_f - 10 \log L}{6{,}02} \qquad (30)$$

wobei hier für $D_f$ der dB-Wert aus Gl. 29 und für L die skalare Größe von Gl. 27 einzusetzen ist. Daraus bestimmt sich dann die effektive Frequenzauflösung zu:

$$q_f = \frac{1}{L} \cdot f_A \cdot 2^{-N_f} \qquad (31)$$

Folglich kann für jeden Einzelfall von kaskadierten Detektionsfiltern mit Abtastratenreduktion der Auflösungsgewinn $\Delta q_f = 2^{(N_f-N)}$ gegenüber den Grundverfahren gleicher Filterlänge, Gl. 11 usw., damit angegeben werden.

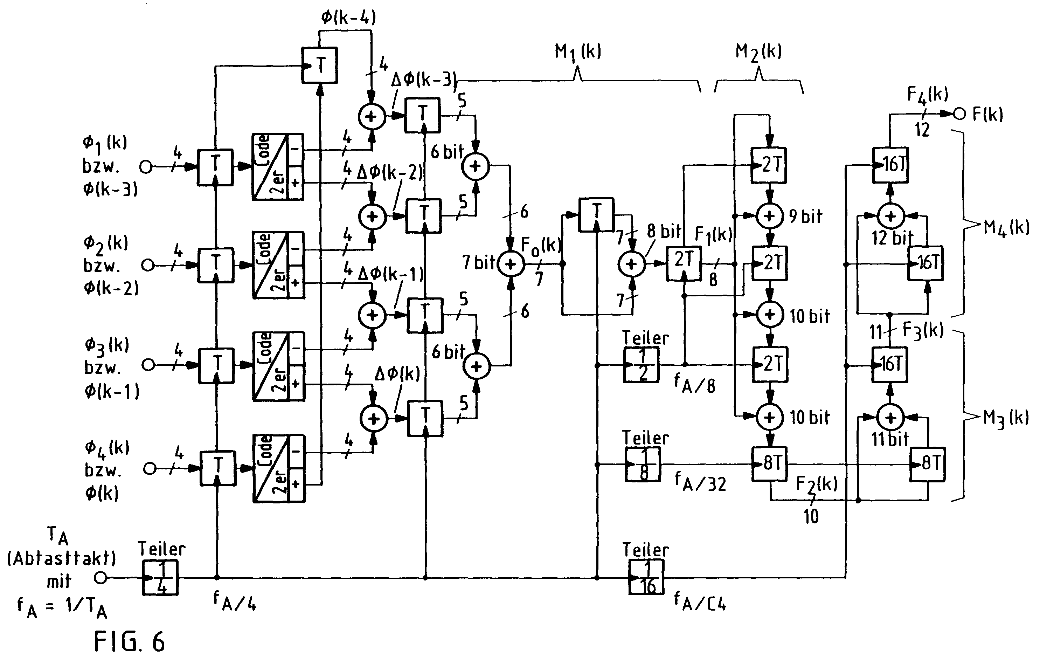

Im folgenden wird nun eine Schaltungsanordnung eines derartigen Detektionsfilter anhand der FIG. 6 näher erläutert. Dabei handelt es sich um ein vierstufiges Detektionsfilter für 4 mal 4bit-Phasenworte $\phi_1(k)$ bis $\phi_4(k)$. Diese wurden aus dem analogen Eingangssignal s(t) beispielsweise in der beschriebenen Weise zunächst in einem 8bit-Johnson-Code erzeugt, der anschließend in einen 4-bit-Binär-Code umgewandelt wurde. Insbesondere für hohe und/ oder sehr hohe Taktfrequenzen, z.B. größer 100 MHz, ist es vorteilhaft, die in serieller Form vorliegenden 4bit-Binär-Phasenworte zunächst einem nicht dargestelltem 1:4 Demultiplexer zuzuleiten, an dessen Ausgang dann in paralleler Form jeweils vier 4bit-Binär-Phasenworte anliegen. Damit wird auf den Verbindungsleitungen von dem Ausgang des Demultiplexers zu dem Eingang ($\phi_1(k)$ bis $\phi_4(k)$) der Anordnung gemäß FIG. 6 die Übertragungsfrequenz vorteilhafterweise um den Faktor 4 gesenkt, so daß schaltungstechnische Probleme, z.B. Übersprechen, vermieden werden. An dem Eingang des Filters liegen daher jeweils vier 4bit-Binär-Eingangsphasenworte $\phi(k)$ gleichzeitig an und werden dementsprechend auch gleichzeitig weiterverarbeitet. Ohne den Verarbeitungsalgorithmus hierbei für das Filter zu verändern, wird die Taktfrequenz bereits ab der ersten Stufe - Subtraktionsstufe - und für alle nachfolgenden Stufen auf ein Viertel der ursprünglichen Abtastfrequenz $f_A$ reduziert. Damit ist für die filterinterne Taktperiodendauer $T = 4/f_A$ zu setzen. Aus Gründen der Übersichtlichkeit wird für die nachfolgenden Formeln jedoch von der Originalabtastfrequenz $f_A$ bzw. von der Originalperiodendauer $T_A = 1/f_A$ ausgegangen. In dem Beispiel ist eine Filterstruktur mit N = 4 Filterstufen gewählt. Die dort mit T, 2T, 8T, 16T bezeichneten Bauelemente sind Verzögerungsglieder, welche die anliegenden Signale um die angegebene Anzahl von Taktperioden $T=4 \cdot T_A$ verzögern. Das Bauelement T verzögert daher mit $T=4 \cdot T_A$, 2T verzögert mit $2T=2 \cdot 4 \cdot T_A$ und so weiter. Hierbei stehen die Teilfilterlängen: $M_1 = 8$, $M_2 = 4$, $M_3 = 2$ und $M_4 = 2$ durch ganzzahlige Potenzen der Zahl 2 im Verhältnis. Dementsprechend gelten dann nach Gl. 25 für die einzelnen Filterstufen die Abtastraten-Reduktionsfaktoren:
$R_1 = 1$, $R_2 = 8$, $R_3 = 4$ und $R_4 = 2$ bzw. nach Gl. 26 für die Abtastraten-Quotienten (Verzögerungsfaktoren)
$r_1 = 1$, $r_2 = 8$, $r_3 = 32$, $r_4 = 64$. Damit kann dann die prinzipielle Rechenvorschrift zur Ermittlung des Frequenzwortes

$$F(k) = \frac{1}{2\pi \cdot 128} \sum_{m_4=1}^{2} \sum_{m_3=1}^{2} \sum_{m_2=1}^{4} \sum_{m_1=0}^{7} \Delta\phi(k-m_4 \cdot m_3 \cdot m_2 \cdot m_1) \text{ mit}$$

$$\Delta\phi(k) = [\phi(k-1)-\phi(k)] \bmod 2\pi \qquad (32)$$

ohne jeglichen Zeitbezug angegeben werden. Dies reicht jedoch vollständig aus, um die wichtigsten deterministischen als auch stochastischen Detektorparameter bestimmen zu können. So ergibt sich aus Gl. 27 eine Rechenwerksauflösung mit $q_o = 0,488 \cdot 10^{-3} \cdot f_A$. Hierbei besitzt der effektive Frequenzfehler nach Gl. 28 den Wert $\sigma_f = 1,127 \cdot 10^{-3}$ und die Gl. 29 liefert für dieses Detektionsfilter einen Signalstörabstand von $D_f = 48.2$ dB. Dies hat nach Gl. 30 eine effektive Bitzahl $N_f = 5,5$ bit zur Folge, mit der sich nach Gl. 31 die effektive Frequenzauflösung zu $q_f = 0,173 \cdot 10^{-3} \cdot f_A$ bestimmen läßt. Damit besitzt dieses Filter eine um das 2,8-fache bessere effektive Frequenzauflösung als es sich aus der Rechenwerksauflösung $q_o$ direkt ergibt.

Dagegen lassen sich die zeit- und frequenzabhängigen Eigenschaften des Detektionsfilters am besten anhand seiner z-transformierten Übertragungsfunktionen

$$M(z) = M_1(z) \cdot M_2(z) \cdot M_3(z) \cdot M_4(z) \qquad \text{mit}$$

$$M_1(z) = \frac{1}{8} (z^0+z^{-1}+z^{-2}+z^{-3}+z^{-4}+z^{-5}+z^{-6}+z^{-7}),$$

$$M_2(z) = \frac{1}{4} z^{-7}(z^0+z^{-8}+z^{-16}+z^{-24}), \qquad (33)$$

$$M_3(z) = \frac{1}{2} z^{-31}(z^0+z^{-32}) \qquad \text{und}$$

$$M_4(z) = \frac{1}{2} z^{-63}(z^0+z^{-64})$$

für das Gesamtfilter M(z) sowie für die Filterstufen $M_i(z)$ erklären. Für die Variable z wird hierbei die allgemein bekannte Grundbeziehung $z = \exp(j2\pi t/T)$ der Z-Transformation verwendet. Zur Herleitung der diskreten und auf $f_A = 1$Hz normierten Amplitudengänge $G_i(K) = |M_i(j2\pi k \cdot t)|$ aus Gl. 33 für das Filter und deren Teilfiltern sind die Formeln der Euler'schen Relation für $z^n \pm z^{-n}$ zweckmäßig. Für eine gerade Filterkoeffizientenanzahl $M_i$ ergibt sich somit ein Amplitudengang:

$$G_i(k) = 2 \cdot \sum_{n=0}^{L_i-1} \cos[t \cdot k \cdot r_i(n+0,5)] \text{ mit } L_i = M_i/2 \qquad (34)$$

und für eine ungerade Filterkoeffizientenanzahl $M_i$:

$$G_i(k)=1+2\cdot \sum_{n=1}^{L_i} \cos[t\cdot k\cdot r_i\cdot n] \quad \text{mit } L_i=(M_i-1)/2 \qquad (35).$$

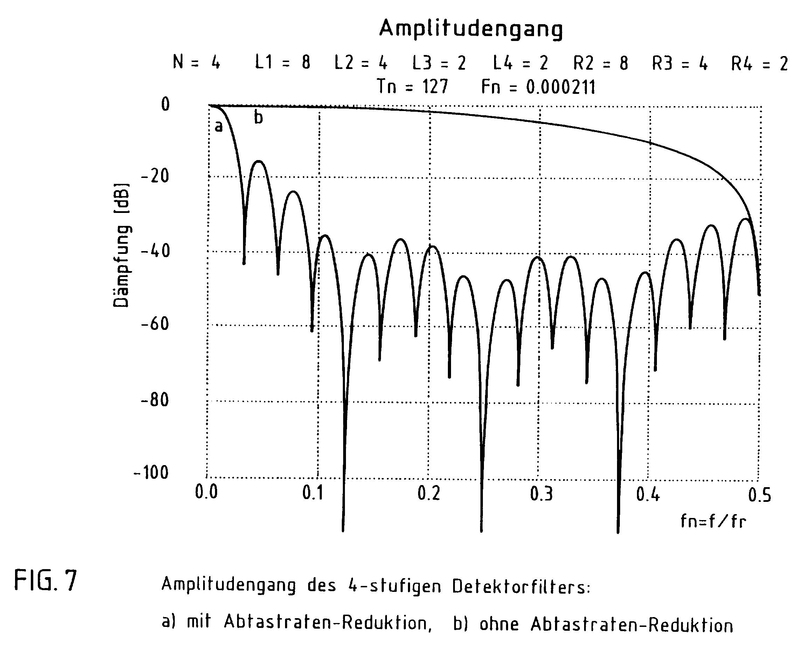

Unter Verwendung der Gl. 34 und 35 werden nun in FIG. 7 für dieses 4-stufige Detektionsfilter die normierten Amplitudengänge für a) mit Abtastraten-Reduktionen und b) ohne Abtastraten Reduktion bezüglich der reduzierten und normierten Abtastbandbreite $f_r = 1/128$ des Frequenzmeßwertes F(k) aufgezeigt. Die in den Kopfzeilen aufgelisteten Parameter beziehen sich hierbei auf das Filter mit Abtastraten-Reduktion.

Bei Vergleich der beiden Kurven in FIG. 7 stellt sich vor allem ein erheblicher Unterschied in den 3dB-Bandbreiten heraus. Die normierte Bandbreite des Filters mit Abtastratenreduktion beträgt hierbei Fn = 0,000211 und ist somit zur Bandbreite, Gl. 10, des äquivalenten Filters ohne Abtastraten-Reduktion um den Wert 18,5 mal kleiner. Dieser großen Verbesserung in der Frequenzauflösungs-Bandbreite steht nur eine relativ geringe Zunahme der Meßzeit von $127\cdot T_A$ auf $164{,}5\cdot T_A$ entgegen. Jedoch ist es in der technischen Realisierung leicht möglich, durch ein optimales "Timing" des Rechenablaufes im Filter diese Meßzeitzunahme von ca. 36 Abtasttaktperioden $T_A$ erheblich zu verringern. Damit erbringt die Kaskadenlösung mit entsprechend reduzierten Abtastratenfaktoren, Gl. 25 und 26, für die einzelnen Filterstufen eine wesentliche Steigerung der (statistischen) Meßgenauigkeit ohne jedoch nennenswerte Verschlechterungen bei der Meßzeit zu erhalten. Außerdem ergibt dieses Verfahren bei der technischen Ausführung den geringsten Aufwand an Speicherzellen und Addierstufen.

Die Erfindung ist nicht auf die beschriebenen Beispiele beschränkt, sondern sinngemäß auf weitere anwendbar. Beispielsweise ermöglichen digitale GaAs-Schaltkreise, monolithisch integrierte Mikrowellen-Bausteine (MMIC) und/oder ECL-Schaltkreise im Picosekundenbereich (Gigabit-Logik) in steigendem Maß eine digitale Signalverarbeitung von hohen und sehr hohen Frequenzen (>0,5 GHz). Damit ergeben sich für das hier beschriebene Momentanfrequenz-Detektionsverfahren in Verbindung mit der Phasen/Digital-Umsetzung immer breitere und neue Anwendungmöglichkeiten auf allen Gebieten der Kommunikations- und Radartechnik. Hinzu kommt noch die erhebliche Verringerung des technischen Aufwandes bei der Realisierung dieses Detektionsfilter-Prinzips. So entfallen unter anderem jegliche Koeffizienten-Multiplizierer, da nur Filterkoeffizienten mit -1, 0 und +1 auftreten können. Somit ermöglicht es eine einfache und extrem schnelle Verarbeitung von quantisierten Phasenwinkelwerten mit reellen Algorithmen, die besonders günstig in Hochgeschwindigkeits-ECL- oder GaAs-Gate-Arrays implementiert werden können.

## Patentansprüche

1. Verfahren zur Momentanfrequenz-Detektion, bei dem aus einem analogen Eingangssignal (s(t)) mittels eines Taktsignales (T) digitale Abtastwerte gebildet werden und aus den Abtastwerten ein digitales Frequenzwort (F(k)), das einem Frequenzanteil des Eingangssignales entspricht, ermittelt wird, <u>dadurch gekennzeichnet,</u>

   - daß durch eine quantisierte Phasenabtastung des analogen Eingangssignals mittels des Taktsignales (T) zunächst zu jedem Takt ein im Johnson-Code vorliegendes Phasenwort gebildet wird,

   - daß aus jedem im Johnson-Code vorliegendem Phasenwort mittels eines 2er-Komplement-Kodierers zwei als 2er-Komplement binär-kodierte Phasenworte ($\varphi(k)$) gebildet werden,

   - daß aus den im 2er-Komplement binär-kodierten Phasenworten ($\varphi(k)$) durch eine Verzögerungsschaltung verzögerte und unverzögerte binär-kodierte Phasenworte erzeugt werden,

   - daß durch eine digitale Addition der verzögerten und der unverzögerten binär-kodierten Phasenworte zunächst vorläufige Frequenzworte ($F_T(k)$) erzeugt werden und

   - daß die vorläufigen Frequenzworte ($F_T(k)$) mittels einer digitalen Mittelwertsbildung (Mittelwertbildner) in endgültige Frequenzworte (F(k)) umgewandelt werden.

2. Verfahren nach Anspruch 1, dadurch gekennzeichnet, daß die Mittelwertsbildung (Mittelwertbildner) ausschließlich mit Hilfe von Verzögerungs- und Additionsstufen erfolgt.

**3.** Verfahren nach Anspruch 1 oder Anspruch 2, dadurch gekennzeichnet, daß aus den Verzögerungs- und Additionsstufen ein digitales Filter mit kanonischer Struktur gebildet wird.

**4.** Verfahren nach Anspruch 1 oder Anspruch 2, dadurch gekennzeichnet, daß aus den Verzögerungs- und Additionsstufen ein digitales Filter mit nicht kanonischer Struktur gebildet wird.

**5.** Verfahren nach einem der vorhergehenden Ansprüche, dadurch gekennzeichnet, daß aus den Verzögerungs- und Additionsstufen ein digitales Filter, das eine Blocksummenaddition enthält, gebildet wird.

**6.** Verfahren nach einem der vorhergehenden Ansprüche, dadurch gekennzeichnet, daß die Mittelwertsbildung (Mittelwertbildner) mittels einer Kaskadierung von mindestens zwei digitalen Filtern, die jeweils als Tiefpaßfilter ausgebildet werden, vorgenommen wird.

**7.** Verfahren nach Anspruch 6, dadurch gekennzeichnet, daß bei der Kaskadierung nach jedem digitalem Filter eine Verringerung der zum Betreiben der Filter erforderlichen Taktrate erfolgt.

**8.** Verfahren nach einem der vorhergehenden Ansprüche, dadurch gekennzeichnet, daß bei einer Addition zweier im 2er-Komplement vorliegender binär-kodierter Phasenworte ($\varphi(k)$) ein Übertrags-Bit hinzugefügt wird.

**9.** Verfahren nach einem der vorhergehenden Ansprüche, dadurch gekennzeichnet,

-- daß aus den in serieller Form vorliegenden 4bit-binär-kodierten Phasenworten mittels eines 1:4 Demultiplexers in vorgebbarer Weise jeweils vier in paralleler Form vorliegende 4bit-binär-kodierte Phasenworte gebildet werden,

-- daß aus den in paralleler Form vorliegenden 4bit-binär-kodierten Phasenworten die Frequenzworte ($F(k)$) gebildet werden und

-- daß auf die Frequenzworte ($F(k)$) die Mittelwertsbildung angewandt wird.

**10.** Verfahren nach einem der vorhergehenden Ansprüche, dadurch gekennzeichnet, daß bei der Auswertung eines als Bandpaßsignal vorliegenden analogen Eingangssignals zu den endgültigen digitalen Frequenzworten ($F(k)$) ein digitaler Frequenz-Korrekturwert ($F_0$), welcher eine das Bandpaßsignal bestimmende Frequenzlage beinhaltet, addiert wird.

**11.** Verfahren nach einem der vorhergehenden Ansprüche, zu Verwendung bei der Detektion und/oder Demodulation von frequenzmodulierten und/oder phasenmodulierten analogen Eingangssignalen.

**Claims**

**1.** Method of detecting instantaneous frequency, in which digital scanning values are formed from an analog input signal ($s(t)$) by means of a pulse signal ($T$) and a digital frequency word ($F(k)$), which corresponds to a frequency component of the input signal, is ascertained from the scanning values, characterised thereby

- that a phase word present in Johnson code is initially formed at each pulse by a quantised phase scanning of the analog input signal by means of the pulse signal ($T$),

- that two phase words ($\varphi(k)$) binary coded as second complement are formed by means of a second complement encoder from each phase word present in Johnson code,

- that delayed and undelayed binary coded phase words are produced by a delay circuit from the phase words ($\varphi(k)$) binary coded in the second complement,

- that initially provisional frequency words ($F_T(k)$) are produced by a digital addition of the delayed and the undelayed binary coded phase words and

- that the provisional frequency words ($F_T(k)$) are converted into final frequency words ($F(k)$) by means of a digital mean value formation (mean value former).

2. Method according to claim 1, characterised thereby that the mean value formation (mean value former) takes place exclusively with the aid of delay and addition stages.

3. Method according to claim 1 or claim 2, characterised thereby that a digital filter with canonical structure is formed from the delay and addition stages.

4. Method according to claim 1 or claim 2, characterised thereby that a digital filter with non-canonical structure is formed from the delay and addition stages.

5. Method according to one of the preceding claims, characterised thereby that a digital filter, which contains a block summation addition, is formed from the delay and addition stages.

6. Method according to one of the preceding claims, characterised thereby that the mean value formation (mean value former) is undertaken by means of a cascading of at least two digital filters which are each constructed as a low-pass filter.

7. Method according to claim 6, characterised thereby that a reduction in the pulse rate required for operation of the filter is effected in the cascading after each digital filter.

8. Method according to one of the preceding claims, characterised thereby that a carry bit is added in the case of an addition of two binary coded phase words ($\varphi(k)$) present in the second complement.

9. Method according to one of the preceding claims, characterised thereby that four 4-bit binary coded phase words present in parallel form are formed each time by means of a 1:4 demultiplexer from the 4-bit binary coded phase words present in serial form, that the frequency words ($F(k)$) are formed from the four 4-bit binary coded phase words present in parallel form and that the mean value formation is applied to the frequency words ($F(k)$).

10. Method according to one of the preceding claims, characterised thereby that in the evaluating of an analog input signal, which is present as a bandpass signal, into the final digital frequency words ($F(k)$) a digital frequency correction value ($F_0$), which contains a frequency position determining the bandpass signal, is added.

11. Method according to one of the preceding claims, for use in the detection and/or demodulation of frequency-modulated and/or phase-modulated input signals.

**Revendications**

1. Procédé de détection de la fréquence instantanée, selon lequel, à partir d'un signal d'entrée analogique (s(t)) au moyen d'un signal d'impulsion T, sont formées des valeurs d'analyse numériques et à partir des valeurs d'analyse est détecté un mot de fréquence numérique ($F(k)$), qui correspond à une composante de fréquence du signal d'entrée, caractérisé en ce que

   - par une analyse de phase quantifiée du signal d'entrée analogique, est formé, au moyen du signal d'impulsion (T), tout d'abord à chaque impulsion, un mot de phase présent dans le code Johnson,
   - à partir de chaque mot de phase présent dans le code Johnson sont formés, au moyen d'un codeur de complément à 2, deux mots de phase codés binaires ($\phi(k)$) en tant que complément à 2,
   - des mots de phase ($\phi(k)$) codés binaires dans le complément à 2 sont générés grâce à un circuit de retard des mots de phase codés binaires retardés et non retardés,
   - par une addition numérique des mots de phase codés binaires retardés et non retardés, sont générés tout d'abord des mots de fréquence provisoires ($F_T(k)$) et
   - les mots de fréquence provisoires ($F_T(k)$) sont convertis en mots de fréquence définitifs ($F(k)$) au moyen d'une formation de valeur moyenne numérique (formateur de valeur moyenne).

2. Procédé selon la revendication 1, caractérisé en ce que la formation de valeur moyenne (formateur de valeur moyenne) s'effectue exclusivement à l'aide d'étages de retard et d'addition.

3. Procédé selon la revendication 1 ou la revendication 2, caractérisé en ce qu'à partir des étages de retard et d'addition est formé un filtre numérique de structure canonique.

4. Procédé selon la revendication 1 ou la revendication 2, caractérisé en ce qu'à partir des étages de retard et d'addition est formé un filtre numérique de structure non canonique.

5. Procédé selon l'une quelconque des revendications précédentes, caractérisé en ce qu'à partir des étages de retard et d'addition est formé un filtre numérique, qui comporte une addition cumulée de blocs.

6. Procédé selon l'une quelconque des revendications précédentes, caractérisé en ce que la formation de valeur moyenne (formateur de valeur moyenne) est effectuée à l'aide d'une succession d'au moins deux filtres numériques, qui sont réalisés respectivement sous la forme d'un filtre passe-bas.

7. Procédé selon la revendication 6, caractérisé en ce que, lors de la succession, après chaque filtre numérique est effectuée une réduction de la vitesse d'impulsion nécessaire au fonctionnement des filtres.

8. Procédé selon l'une quelconque des revendications précédentes, caractérisé en ce que, lors d'une addition de deux mots de phase ($\phi(k)$) codés binaires présents dans le complément à 2 est ajouté un bit de transfert.

9. Procédé selon l'une quelconque des revendications précédentes, caractérisé en ce que

   - à partir des mots de phase codés binaires à 4 bits présents sous forme sérielle sont formés au moyen d'un démultiplexeur 1:4 de manière prédéterminée quatre mots de phase codés binaires à quatre bits présents sous forme parallèle,
   - à partir des mots de phase codés binaires à quatre bits présents sous forme parallèle sont formés les mots de fréquence ($F(k)$) et
   - la formation de valeur moyenne est appliquée au mots de fréquence ($F(k)$).

10. Procédé selon l'une quelconque des revendications précédentes, caractérisé en ce que, lors de l'évaluation d'un signal d'entrée analogique présent en tant que signal passe-bande est ajoutée, aux mots de fréquence numériques définitifs ($F(k)$), une valeur de correction de fréquence numérique ($F_0$), qui comporte une position en fréquence déterminant le signal passe-bande.

11. Procédé selon l'une quelconque des revendications précédentes pour l'utilisation lors de la détection et/ou de la démodulation de signaux d'entrée analogiques modulés en fréquence et/ou modulés en phase.

FIG. 1

s(t) Eingangs-Signal

Johnson Sequenzen:

$sq_1(t)$

$sq_2(t)$

$sq_3(t)$

$sq_4(t)$

$sq_5(t)$

$sq_6(t)$

$sq_7(t)$

$sq_8(t)$

k+1 k+2

k

θ bzw τ

EP 0 609 707 B1

a) Prinzipschaltung mit einem Phasen/Digital-Umsetzer für
   Bandpaßsignale (Quadratursignale)

b) Prinzipielle Rechenwerksstruktur des Detektors

c) Subtrahierer zur Frequenzwert-Bestimmung von $F_T(k)$
   im 2-er-Komplement (360°-Modulosubtraktion)

FIG. 2

a) kanonische Struktur mit Multisummanden-Addierern (MSA-Filter)

b) nicht kanonische Struktur mit einzelnen Zweisummanden-Addierern (ZSA-Filter)

c) allgemeine Struktur mit Multi-Differenzstufen und Multisummanden-Addierern (DSA-Filter)

# FIG. 3

a) kanonische Struktur mit zwei Blocksummen-Addierern (BSA-Filter) und einem Blocksummen-Subtrahierer

b) nicht kanonische Struktur mit einzelnen Zweisummanden-Addierern (BZA-Filter) und -Subtrahierern

FIG. 4

EP 0 609 707 B1

a) Schaltungstechnische Kaskadierung und Abtastung der Teilfilter

b) Zur Berechnung der z-Übertragungsfunktionen der Mittelungsfilter

FIG. 5

EP 0 609 707 B1

FIG. 6

**Amplitudengang**

N = 4   L1 = 8   L2 = 4   L3 = 2   L4 = 2   R2 = 8   R3 = 4   R4 = 2
Tn = 127   Fn = 0.000211

$f_n = f/f_r$

Dämpfung [dB]

Amplitudengang des 4-stufigen Detektorfilters:

a) mit Abtastraten-Reduktion,   b) ohne Abtastraten-Reduktion

FIG. 7